# EUROPEAN PATENT APPLICATION

(11) **EP 3 591 695 A1**
(43) Date of publication of application: **08.01.2020**
(21) Application number: 18182299.0
(22) Date of filing: 06.07.2018
(51) Int. Cl.: H01L 21/677, H01L 21/683

(54) **TRANSPORT APPARATUS FOR TRANSPORTING WAFER-SHAPED OBJECTS**

(71) Applicant: Meyer Burger AG, 3645 GWATT (Thun) (CH)
(72) Inventor: BAERFUSS, Frederic, 3600 Thun (CH); MESSERLI, Beat, 3600 Thun (CH)
(74) Representative: Patentbüro Paul Rosenich AG

(57) **Abstract**

The invention relates to a transport apparatus (1) for transporting wafer-shaped objects (2), preferably wafers and/or solar cells, comprising
- a lifting device (3) for moving wafers-shaped objects (2) in a lifting direction (R), wherein preferably the lifting direction (R) is vertical and/or wherein preferably the lifting direction (R) is transverse, preferably perpendicular to the planes the wafer-shaped objects (2) extend in,
- at least one electrical contacting means (4) for contacting the wafer-shaped objects (2),
- a removing device (5) for removing wafer-shaped objects (2) from the lifting device (3), the removing device (5) comprising at least one, preferably at least two, electrode(s) (6) for holding wafer-shaped objects (2) by electrostatic force, and
means (7) for creating a potential difference (Φ₁-Φ₂) between the at least one electrode (6) of the removing device (5) and the electrical contacting means (4).

## Description

The invention relates to a transport apparatus for transporting wafer-shaped objects, preferably wafers and/or solar cells. Moreover the invention relates to a joining device for joining at least one wafer-shaped object, preferably a solar cell with a foil, preferably a wire foil. The invention further relates to a method of transporting wafer-shaped objects with a transport device.

US9199791B2 discloses a device and method for buffer-storing a multiplicity of wafer-type workpieces vertically one above another and individually without the workpieces touching one another. The device comprises a frame, at least two transport elements which circulate in a vertical direction. The device further comprises a multiplicity of bearing areas for the horizontal mounting of workpieces, a loading position and a stationary removal device.

In wafer transport devices the problem arises, that a significant proportion of the transported wafers are damaged by components of the transport device.

It is therefore an object of the invention to handle the wafers in a very smooth manner. Particularly, the components of the transport device coming into direct contact with the wafers should be designed such that the receiving, transport and releasing processes are smooth enough in order to guarantee a wafer throughput with substantially no wafer losses due to damages. At the same time it is a further object of the invention to improving a wafer receiving or gripping action by a component of the transporting apparatus. The gripping action should be reliable and the gripping force essentially constant for all wafer-shaped object.

The object is achieved by a transport apparatus for transporting wafer-shaped objects, preferably wafers and/or solar cells, wherein the transport apparatus comprises:
- a lifting device for moving wafers-shaped objects in a lifting direction, wherein preferably the lifting direction is vertical and/or wherein preferably the lifting direction is transverse, preferably perpendicular to the planes the wafer-shaped objects extend in,
- at least one electrical contacting means for contacting the wafer-shaped objects,
- a removing device for removing wafer-shaped objects from the lifting device, the removing device comprising at least one, preferably at least two, electrode(s) for holding wafer-shaped objects by electrostatic force, and
- means for creating a potential difference between the at least one electrode of the removing device and the electrical contacting means.

The means for creating a potential difference guarantees that the wafer-shaped objects will be gripped by the removing device with a well-defined electrostatic force. I.e. the gripping force, which is not only dependent of the charging level of the electrode but also of the charge state of the wafer-shaped object, can be held constant and/or set to a defined value. The potential difference defines the electrostatic force acting on the wafer-shaped object when being gripped by the removing device.

The means for creating a potential difference prevents the wafer-shaped objects to be charged in an undefined and undesired manner during their transport in the lifting device. Especially when solar cells are transported, the polarity of the potential can be chosen depending on the material the cells are made of (n-type or p-type) such that the cells are gripped with a constant force.

The means for creating a potential difference between the at least one electrode of the removing device and the electrical contacting means may comprise electrical connections for connecting different electrical potentials and/or a voltage source with the at least one electrode of the removing device and the electrical contacting means. The means for creating a potential difference may, preferably in the completely assembled state of the transporting device, comprise two different electrical potentials and/or a voltage source. One of the electrical potentials may be e.g. ground potential.

In an embodiment the means for creating a potential difference may comprise a discharging means for discharging wafer-shaped objects preferably during their transport within the lifting device (if they are e.g. electrically charged in an undesired manner). Discharging may be done e.g. by means of an electrical conductor but also e.g. by means of high-frequency electrical field applied to the wafers and/or an ionizer by applying ionizing radiation (ionizing radiation system).

The electrical contacting means may be e.g. an electrical conductor but may also be e.g. a means for applying a liquid or ionized fluid or gas, e.g. ionized air, to the wafer-shaped objects to bring them to a certain potential and/or to electrically discharge them.

The electrical contacting means for contacting the wafer-shaped objects may be formed as or may comprise an electrically conductive contact area or electrically conductive contact or supporting surface, which holds and/or contacts the wafer-shaped objects during their transport in the lifting device. The electrical contacting means may be a supporting element, a brush, a roller, etc.

In a preferred embodiment the wafer-shaped objects to be transported by means of the transporting apparatus are wafers or solar cells, preferably made from semiconductor material. The wafer-shaped objects may be made from materials such as (n-type, p-type) silicon (polycrystalline or monocrystalline or mono-like), germanium, GaAs, InP, quartzes, sapphire and/or ceramic materials.

The thickness of the wafer-shaped objects to be transported by means of the transporting apparatus is preferably smaller than 2mm, preferably smaller than 1mm.

Within the plane of the wafer-shaped objects they may have any contour such as square, pseudo-square, circular, half cells, etc.

The removing device may be formed as an electrostatic gripper having a flat receiving surface for receiving a wafer-shaped object.

In a preferred embodiment the wafer-shaped objects are transported by the lifting device in stacks of at least two, preferably at least 10 wafer-shaped objects. The removing device may then be adapted as singulation device removing (singulating) the wafer-shaped objects individually one after the other from the lifting device.

In a preferred embodiment the electrical contacting means is arranged in the lifting device and/or wherein the electrical contacting means is an integral part of the lifting device, preferably an integral part of a moveable lifting portion of the lifting device, wherein preferably the lifting portion is formed by circulating means extending in lifting direction, such as at least one circulating belt with supporting element(s) for supporting the wafer-shaped objects.

Due to the arrangement of the electrical contacting means in the lifting device the wafer-shaped objects are brought to or held at a defined potential, e.g. positive or negative potential, ground potential (de-charged state) immediately before they will be gripped by the removing device.

In a preferred embodiment the electrical contacting means is connected or connectable to a first electrical potential and the electrode is connected or connectable to a second electrical potential which is different to the first electrical potential.

In a preferred embodiment one of the electrical contacting means and the electrode, preferably the electrical contacting means, is connected or connectable to a ground potential and the other, preferably the electrode, is connected or connectable to a positive or negative potential.

In a preferred embodiment the lifting device comprises at least one, preferably at least two, lifting portion(s) moveable in a lifting direction, preferably a circulating means extending in lifting direction or a worm thread or a hydraulic or pneumatic cylinder, wherein the at least one moveable lifting portion comprises or is connected to at least one supporting element for supporting the wafer-shaped objects in an orientation which is transverse, preferably perpendicular, to the lifting direction, wherein the electrical contacting means is at least partly formed by the at least one lifting portion and/or supporting element. Here, the moveable lifting portion and/or the supporting element(s) has/have - additionally to the lifting function - the function of electrically contacting the wafer-shaped objects.

In a preferred embodiment the electrical resistance of the electrical contacting means has a value between 10 kΩ and 1000 kΩ, preferably between 50 kΩ and 200 kΩ.

In a preferred embodiment the electrical contacting means is an integral part or portion of the moveable lifting portion of the lifting device - which is preferably a circulating belt. The electrical resistance of the material forming the lifting portion - preferably the lifting belt - has then preferably a value between 10 kΩ and 1000 kΩ, preferably between 50 kΩ and 200 kΩ.

In a preferred embodiment the electrical contacting means comprises a brush and/or a roller and/or a liquid and/or a discharging electrode. Here, the electrical contacting means may temporarily contact the wafer-shaped objects, when traveling in lifting direction. The electrical contacting means may also be - relative to the moveable lifting portion - a stationary component of the lifting device.

In a preferred embodiment the electrical contacting means is electrically connected to a constant potential and/or ground potential.

In a preferred embodiment the lifting portion(s), preferably in form of a circulating means, is/are made from a polymer material, preferably rubber and/or plastic, wherein preferably the polymer material is permeated by electrically conductive particles to render it conductive, preferably establishing a conductive path from the supporting element(s) to the first electrical potential. Here, the circulating means does not only gives the lifting action, but is also responsible for the electrical contacting of the wafer-shaped objects.

In a preferred embodiment the at least one circulating means comprises a circulating belt, preferably formed in one piece with the supporting elements, wherein preferably the at least one circulating means is designed as a cam belt, preferably as a cam toothed belt.

In a preferred embodiment the lifting device comprises at least two circulating means each having supporting elements for supporting the wafer-shaped objects, wherein the at least two circulating means are arranged as to receive wafer-shaped objects in between them. Here, the wafers may be transported in a mechanically stable way. It is possible that both circulating means or only one circulating means act(s) as electrical contacting means.

In a preferred embodiment the at least one removing device has a receiving surface for receiving a wafer-shaped object, wherein preferably the electrode is arranged, preferably directly, behind the receiving surface. The removing device may be formed as electrostatic gripper. It is preferred if the electrode of the removing device is chargeable to different charging states, e.g. by a controllable voltage source.

In a preferred embodiment the receiving surface of the at least one removing device is transverse, preferably perpendicular, to the lifting direction of the lifting device and/or wherein the receiving surface of the at least one removing device faces in a direction which is opposite to the lifting direction, preferably in downward direction. The orientation of the wafer-shaped objects has not to be changed when being transferred from the lifting device to the removing device.

In a preferred embodiment the at least one removing device and/or the receiving surface of the removing device is moveable between a removing position for gripping a wafer-shaped object from the lifting device and a delivery position for releasing the gripped wafer-shaped object, preferably onto a processing base, wherein preferably the removing position and the delivery position being mainly within one plane. In such a way the wafer-shaped objects may be efficiently removed from the lifting device and brought to a place, which is preferably horizontally distanced from the lifting device.

In a preferred embodiment the at least one removing device and/or the receiving surface of the removing device is rotatable about a pivot axis, wherein preferably the pivot axis is vertical and/or parallel to the lifting direction of the lifting device.

In a preferred embodiment the removing device comprises at least two at least two receiving surfaces for receiving a wafer-shaped object which are connected with each other and rotatable about the pivot axis, wherein preferably the pivot axis is arranged between the at least two receiving surfaces.

In these embodiments the removing action is realized by means of a rotation. In the case of at least two receiving surfaces at least two wafer-shaped objects may be handled at the same time: while one wafer-shaped object is electrostatically gripped from the lifting device (received by a first receiving surface of removing device), another wafer shaped object may be released from the removing device (released from a second receiving surface of removing device). The transport-throughput may be significantly increased by such an embodiment.

The object is also achieved with a joining device for joining at least one wafer-shaped object, preferably a solar cell with a foil, preferably a wire foil, comprising a joining area and a transport device according to one of the preceding claims for transporting wafer-shaped objects to the joining area. In joining devices it is of great importance to transport wafer-shaped objects particularly solar cells without imparting damages to it. In the joined state it is difficult to detect damages that may negatively influence the performance of the resulting solar module. Moreover, joining devices usually work on different levels. This requires bringing solar cells to different levels.

The object is also achieved by a method of transporting wafer-shaped objects with a transport device according to the invention, preferably in a joining device according to the invention, comprising the steps of
- lifting by means of the lifting device a plurality of wafer-shaped objects, preferably as stacks of wafer-shaped objects, and
- removing by means of the removing device wafer-shaped objects from the lifting device, preferably one after the other.

Further embodiments of the invention are indicated in the figures and in the dependent claims. The list of reference marks forms part of the disclosure. The invention will now be explained in detail by the drawings. In the drawings:
- Fig. 1: shows a transport apparatus for transporting wafer-shaped objects according to the invention,
- Fig. 2: shows an embodiment of a transport apparatus, and
- Fig. 3: shows a joining device for joining at least one wafer-shaped object with a foil.

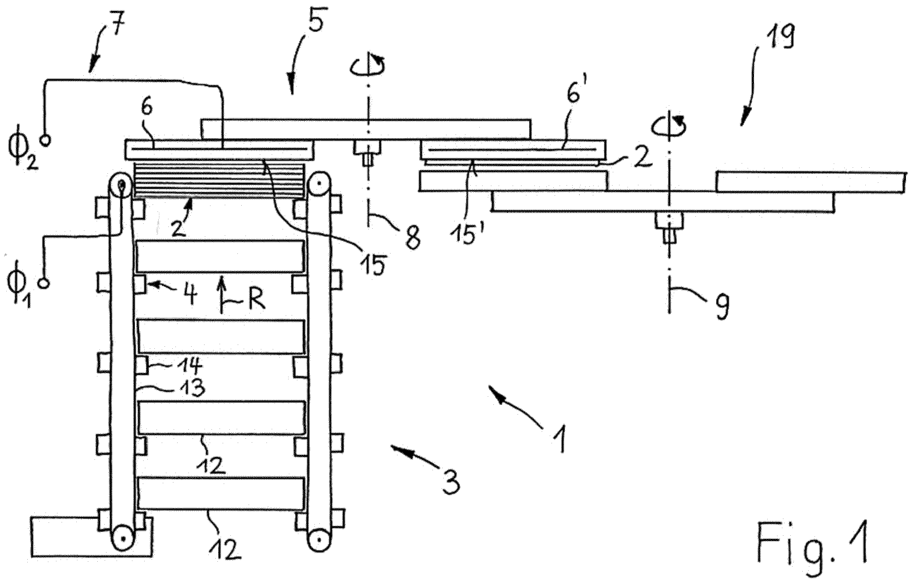

Fig. 1 shows a transport apparatus 1 for transporting wafer-shaped objects 2, preferably wafers and/or solar cells. A lifting device 3 moves wafers-shaped objects 2 in a lifting direction R. In the preferred embodiment shown the lifting direction is vertical and transverse (here: perpendicular) to the planes the wafer-shaped objects 2 extend in.

The transport apparatus 1 comprises at least one electrical contacting means 4 for contacting the wafer-shaped objects. In the embodiment of Fig. 1 the electrical contacting means 4 is arranged in the lifting device 1 and is an integral part of the lifting device 1. The lifting device 3 comprises moveable lifting portions 13 which are formed by circulating means extending in lifting direction R, such as circulating belts with supporting elements 14 for supporting the wafer-shaped objects 2. The electrical contacting means 4 is connected to a first electrical potential Φ₁.

Transporting apparatus 1 also comprises a removing device 5 for removing wafer-shaped objects 2 from the lifting device 3. An electrode 6 within the removing device 5 serves for gripping and holding wafer-shaped objects 2 by electrostatic force. In the present embodiment removing device 5 comprises a further electrode 6'. First electrode 6 is associated with a first receiving surface 15 for receiving a wafer-shaped object 2; and second electrode 6' is associated with a second receiving surface 15' for receiving a another wafer-shaped object 2. The electrodes 6, 6' are arranged, preferably directly, behind the receiving surfaces 15, 15'.

As will be described below in more detail, removing device 5 is rotatable about a (vertical) pivot axis 8.

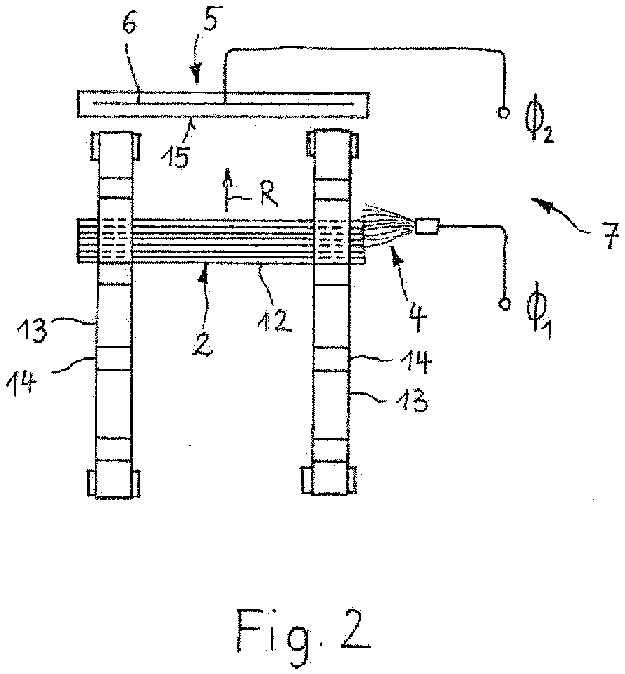

Finally, means 7 for creating a potential difference Φ₁-Φ₂ between the at least one electrode 6 of the removing device 5 and the electrical contacting means 4 is provided. The means 7 for creating a potential difference may comprise electrical connections for connecting different electrical potentials Φ₁, Φ₂ and/or a voltage source with the at least one electrode of the removing device and the electrical contacting means (Fig. 1 and 2). The means 7 for creating a potential difference also comprises two different electrical potentials Φ₁, Φ₂ and/or a voltage source (Fig. 1 and 2). One of the electrical potentials Φ₁, Φ₂ may be e.g. ground potential.

As can be seen from Fig. 1 and 2 the electrical contacting means 4 is connected to a first electrical potential Φ₁ and the electrode 6 of the removing device 5 is connected to a second electrical potential Φ₂ which is different to the first electrical potential Φ₁. The difference between the potentials defines the electrostatic force acting on the wafer-shaped object when being gripped by the removing device.

In an embodiment one of the electrical contacting means 4 and the electrode 6, preferably the electrical contacting means 4, is connected to a ground potential and the other, preferably the electrode 6, is connected to a positive or negative potential.

As already mentioned with respect to Fig. 1 the lifting device 3 may comprise lifting portion(s) 13 moveable in lifting direction R. A lifting portion 13 may be formed as circulating means extending in lifting direction R. Alternatively, a worm thread or a hydraulic or pneumatic cylinder may be provided. The lifting portions 13 each comprise or is connected to at least one supporting element 14 for supporting the wafer-shaped objects 2 in an orientation which is transverse, preferably perpendicular, to the lifting direction R.

The electrical contacting means 4 is at least partly formed by the at least one lifting portion 13 and/or supporting element 14. The electrical contacting means 4 may comprises a contact or support surface coming into contact with the wafer-shaped objects 2.

In a preferred embodiment the electrical resistance of the electrical contacting means has a value between 10 kΩ and 1000 kΩ, preferably between 50 kΩ and 200 kΩ.

In a preferred embodiment the electrical contacting means is an integral part or portion of the moveable lifting portion of the lifting device - which is preferably a circulating belt. The electrical resistance of the material forming the lifting portion - preferably the lifting belt or supporting elements - has then preferably a value between 10 kΩ and 1000 kΩ, preferably between 50 kΩ and 200 kΩ.

In an alternative embodiment the electrical contacting means 4 may comprise a brush (Fig. 2) and/or a roller and/or a liquid and/or a discharging electrode (discharge system), preferably capable of applying a high-frequency electrical field to the wafers and/or an ionizer (ionizing radiation system) such as the Panasonic ER-X001 or Hamamatsu's PhotoIonBar. It would be also possible that the wafer-shaped objects 2 during their transport in the lifting device only temporarily come into contact with the electrical contacting means 4 to be charged to a certain level (see Fig. 2).

The lifting portion(s) 13, preferably in form of circulating means, is/are preferably made from a polymer material, preferably rubber and/or plastic. The polymer material may be permeated by electrically conductive particles to render it conductive, preferably establishing a conductive path from the supporting element(s) 14 to the first electrical potential Φ1.

The lifting portion(s) 13 may comprise at least one circulating belt, preferably formed in one piece with the supporting elements 14. The at least one circulating belt may be designed as a cam belt, preferably as a cam toothed belt.

In Fig. 1 two circulating belts - each having supporting elements 14 for supporting the wafer-shaped objects 2 - are arranged as to receive wafer-shaped objects 2 in between them.

As can be seen from Fig 1 the receiving surfaces 15, 15' of the removing device 5 are transverse, preferably perpendicular, to the lifting direction R of the lifting device 3 and each faces in a direction which is opposite to the lifting direction R, here in downward direction.

As can be also seen from Fig. 1 the receiving surfaces 15, 15' of the removing device 5 are moveable between a removing position for gripping a wafer-shaped object 2 from the lifting device 3 (say receiving surface 15 above lifting device 3) and a delivery position for releasing the gripped wafer-shaped object 2 (say receiving surface 15 above rotating device 19), preferably onto a processing base. This is done by rotation of removing device about a pivot axis 8. The receiving surfaces 15, 15' which are connected with each other are rotatable about the pivot axis 8. The pivot axis 8 is arranged between the two receiving surfaces 15, 15'.

The removing position and the delivery position may be mainly within one plane. In the present embodiment the processing base is a rotating device 19 which rotates the wafer-shaped objects 2 about a (vertical and parallel to the lifting direction R) pivot axis 9, preferably about 180°.

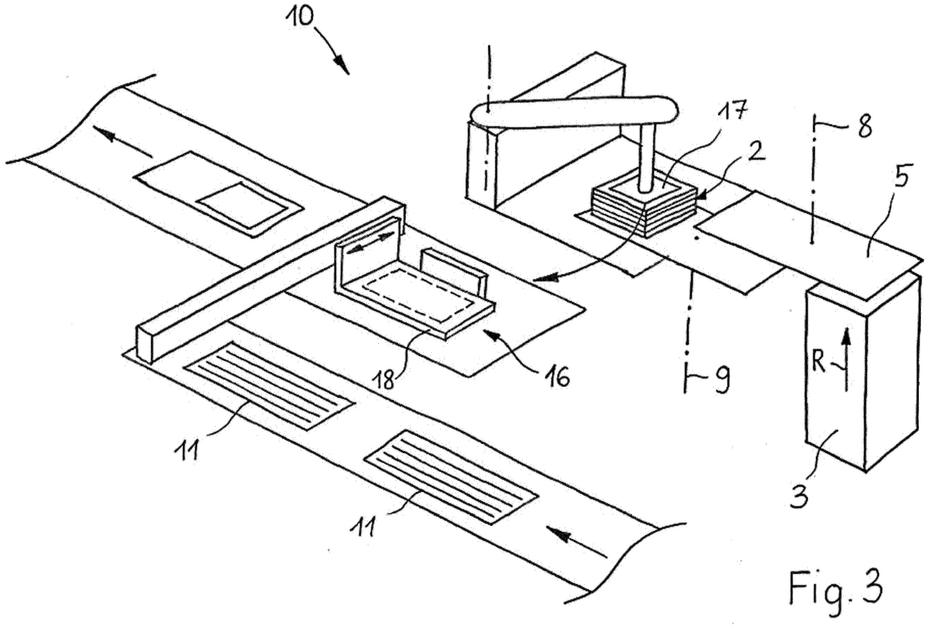

Fig. 3 shows a joining device 10 for joining at least one wafer-shaped object 2, preferably a solar cell, with a foil 11, preferably a wire foil. The joining device comprises a joining area 16 and a transport device 1 according to the invention for transporting wafer-shaped objects 2 towards the joining area 16. As can be seen from Fig. 3 foils 11 are provided on a conveyor and transferred by means of a gripper 18 to the joining area 16 which may be also part of a conveyor. The wafer-shaped objects 2 are transported by means of the transporting apparatus 1 to an intermediate position and then transferred by means of a gripper 18 to the joining area 16.

The invention also relates to a method of transporting wafer-shaped objects 2 with a transport device 1, preferably in a joining device 10, comprising the steps of
- lifting by means of the lifting device 3 a plurality of wafer-shaped objects 2, preferably as stacks 12 of wafer-shaped objects 2, and
- removing by means of the removing device 5 wafer-shaped objects 2 from the lifting device 3, preferably one after the other.

The invention is not restricted to these embodiments. Other variants will be obvious for the person skilled in the art and are considered to lie within the scope of the invention as formulated in the following claims. Individual features described in all parts of the above specification, particularly with respect to the figures may be combined with each other to form other embodiments and/or applied mutatis mutandis to what is described in the claims and to the rest of the description, even if the features are described in respect to or in combination with other features.

### List of reference signs

- 1: transport apparatus
- 2: wafer-shaped object
- 3: lifting device
- 4: electrical contacting means
- 5: removing device
- 6: electrode of removing device 5
- 6': electrode of removing device 5
- 7: means for creating a potential difference
- 8: pivot axis of removing device 5
- 9: pivot axis
- 10: joining device
- 11: foil
- 12: stack of wafer-shaped objects 2
- 13: lifting portion
- 14: supporting element
- 15: receiving surface
- 16: joining area
- 17: gripper
- 18: gripper
- 19: rotating device
- R: lifting direction

## Claims

1. Transport apparatus (1) for transporting wafer-shaped objects (2), preferably wafers and/or solar cells, comprising
- a lifting device (3) for moving wafers-shaped objects (2) in a lifting direction (R), wherein preferably the lifting direction (R) is vertical and/or wherein preferably the lifting direction (R) is transverse, preferably perpendicular to the planes the wafer-shaped objects (2) extend in,
- at least one electrical contacting means (4) for contacting the wafer-shaped objects (2),
- a removing device (5) for removing wafer-shaped objects (2) from the lifting device (3), the removing device (5) comprising at least one, preferably at least two, electrode(s) (6) for holding wafer-shaped objects (2) by electrostatic force, and
- means (7) for creating a potential difference (Φ₁-Φ₂) between the at least one electrode (6) of the removing device (5) and the electrical contacting means (4).

2. Transport apparatus according to claim 1, wherein the electrical contacting means (4) is arranged in the lifting device (1) and/or wherein the electrical contacting means (4) is an integral part of the lifting device (1), preferably an integral part of a moveable lifting portion (13) of the lifting device (3), wherein preferably the lifting portion (13) is formed by circulating means extending in lifting direction (R), such as at least one circulating belt with supporting element(s) (14) for supporting the wafer-shaped objects (2).

3. Transport apparatus according to claim 1 or 2, wherein the electrical contacting means (4) is connected or connectable to a first electrical potential (Φ₁) and the electrode (6) of the removing device (5) is connected or connectable to a second electrical potential (Φ₂) which is different to the first electrical potential (Φ₁).

4. Transport apparatus according to one of the preceding claims, wherein one of the electrical contacting means (4) and the electrode (6), preferably the electrical contacting means (4), is connected or connectable to a ground potential and the other, preferably the electrode (6), is connected or connectable to a positive or negative potential.

5. Transport apparatus according to one of the preceding claims, wherein the lifting device (3) comprises at least one, preferably at least two, lifting portion(s) (13) moveable in a lifting direction (R), preferably a circulating means extending in lifting direction (R) or a worm thread or a hydraulic or pneumatic cylinder, wherein the at least one moveable lifting portion (13) comprises or is connected to at least one supporting element (14) for supporting the wafer-shaped objects (2) in an orientation which is transverse, preferably perpendicular, to the lifting direction (R),
wherein the electrical contacting means (4) is at least partly formed by the at least one lifting portion (13) and/or supporting element.

6. Transport apparatus according to one of the preceding claims, wherein the electrical resistance of the electrical contacting means (4) has a value between 10 kΩ and 1000 kΩ, preferably between 50 kΩ and 200 kΩ.

7. Transport apparatus according to one of the preceding claims, wherein the electrical contacting means (4) comprises a brush and/or a roller and/or a liquid and/or a discharging electrode.

8. Transport apparatus according to one of the preceding claims, wherein the lifting portion(s) (13), preferably a circulating means, is made from a polymer material, preferably rubber and/or plastic, wherein preferably the polymer material is permeated by electrically conductive particles to render it conductive, preferably establishing a conductive path from the supporting element(s) (14) to the first electrical potential (Φ₁).

9. Transport apparatus according to one of the preceding claims, wherein the at least one lifting portion (13) comprises a at least one circulating belt, preferably formed in one piece with the supporting elements (14), wherein preferably the at least one circulating belt is designed as a cam belt, preferably as a cam toothed belt.

10. Transport apparatus according to one of the preceding claims, wherein the lifting device (3) comprises at least two circulating belts each having supporting elements (14) for supporting the wafer-shaped objects (2), wherein the at least two circulating belts are arranged as to receive wafer-shaped objects (2) in between them.

11. Transport apparatus according to one of the preceding claims, wherein the at least one removing device (5) has a receiving surface (15) for receiving a wafer-shaped object (2), wherein preferably the electrode (6) is arranged, preferably directly, behind the receiving surface (15).

12. Transport apparatus according to one of the preceding claims, wherein the receiving surface (15) of the at least one removing device (5) is transverse, preferably perpendicular, to the lifting direction (R) of the lifting device (3)
and/or wherein the receiving surface (15) of the at least one removing device (5) faces in a direction which is opposite to the lifting direction (R), preferably in downward direction.

13. Transport apparatus according to one of the preceding claims, wherein the at least one removing device (5) and/or the receiving surface (15) of the removing device (5) is moveable between a removing position for gripping a wafer-shaped object (2) from the lifting device (3) and a delivery position for releasing the gripped wafer-shaped object (2), preferably onto a processing base, wherein preferably the removing position and the delivery position being mainly within one plane.

14. Transport apparatus according to one of the preceding claims, wherein the at least one removing device (5) and/or the receiving surface (15) of the removing device (5) is rotatable about a pivot axis (8), wherein preferably the pivot axis (8) is vertical and/or parallel to the lifting direction (R) of the lifting device (3).

15. Transport apparatus according to one of the preceding claims, wherein the removing device (5) comprises at least two receiving surfaces (15, 15') for receiving wafer-shaped objects (2) which are connected with each other and rotatable about the pivot axis (8), wherein preferably the pivot axis (8) is arranged between the at least two receiving surfaces (15, 15').

16. Joining device (10) for joining at least one wafer-shaped object (2), preferably a solar cell, with a foil (11), preferably a wire foil, comprising a joining area (16) and a transport device (1) according to one of the preceding claims for transporting wafer-shaped objects (2) to the joining area (16).

17. Method of transporting wafer-shaped objects (2) with a transport device (1) according to one of the claims 1 to 15, preferably in a joining device (10) according to claim 16, comprising the steps of
- lifting by means of the lifting device (3) a plurality of wafer-shaped objects (2), preferably as stacks (12) of wafer-shaped objects (2), and
- removing by means of the removing device (5) wafer-shaped objects (2) from the lifting device (3), preferably one after the other.
